# FASCICULE DE BREVET EUROPEEN

(11) **EP 3 195 474 B1**
(45) Date de publication et mention de la délivrance du brevet: **16.12.2020**
(21) Numéro de dépôt: 15763025.2
(22) Date de dépôt: 15.09.2015
(51) Int. Cl.: H03K 17/60, H03K 17/74

(54) **CIRCUIT ÉLECTRIQUE DE COMMANDE D'UN ÉQUIPEMENT ÉLECTRIQUE À FORTE INTÉGRITÉ**
ELEKTRISCHE SCHALTUNG ZUR STEUERUNG EINER ELEKTRISCHEN VORRICHTUNG MIT HOHER INTEGRITÄT
ELECTRICAL CIRCUIT FOR CONTROL OF AN ELECTRICAL DEVICE WITH HIGH INTEGRITY

(30) Priorité: 16.09.2014 FR 1458745
(43) Date de publication de la demande: 26.07.2017
(73) Titulaire: Safran Electronics & Defense, 92100 Boulogne-Billancourt (FR)
(72) Inventeur: KARNIEWICZ, Eric, 92100 Boulogne-Billancourt (FR); MONTOYA, Michael, 92100 Boulogne-Billancourt (FR); CHARRIER, Nicolas, 92100 Boulogne-Billancourt (FR); MARTI, Nicolas, 92100 Boulogne-Billancourt (FR)
(74) Mandataire: Regimbeau
(86) Numéro de dépôt international: PCT/EP2015/071125
(87) Numéro de publication internationale: WO 2016/041981

(56) Documents cités:
- EP-A1- 3 172 412
- AU-A1- 2007 240 174
- CN-Y- 201 173 551
- DE-A1- 2 163 495
- FR-A1- 2 969 862
- FR-A1- 3 023 872

## Description

### DOMAINE TECHNIQUE GENERAL ET ETAT DE LA TECHNIQUE

L'invention concerne le domaine de l'électronique et plus particulièrement celui de la commande d'un équipement électrique intégré dans une installation électrique.

On connait des dispositifs électriques commandés par des interrupteurs dit « normalement ouverts ». Dans ce cas, un interrupteur normalement ouvert est connecté entre une source de tension de l'équipement électrique et l'équipement électrique. Ainsi, en commandant l'interrupteur normalement ouvert, on peut commander l'alimentation de l'équipement électrique.

Afin d'améliorer la commande du dispositif électrique, ces derniers peuvent être commandés par des interrupteurs dit « normalement fermés ». Dans ce cas, un interrupteur normalement fermé est connecté entre une source de tension de l'équipement électrique et l'équipement électrique. Ainsi, au repos, en l'absence de commande, l'interrupteur normalement fermé commande l'alimentation électrique de l'équipement électrique, commande qui permet de déconnecter l'alimentation électrique du dispositif électrique. Un tel interrupteur est décrit par exemple in FR2969862.

Toutefois ces solutions ne sont pas satisfaisantes en termes de niveau de sécurité, les implémentations actuelles n'étant pas satisfaisantes.

### PRESENTATION DE L'INVENTION

Un but de l'invention est d'améliorer la commande d'un équipement électrique au moyen d'un interrupteur « normalement fermé » naturellement, c'est-à-dire en l'absence de commande.

A cet effet, l'invention propose un circuit de commande d'un équipement électrique selon la revendication 1.

L'invention est avantageusement complétée par les caractéristiques suivantes, prises seules ou en une quelconque de leur combinaison techniquement possible :
- l'interrupteur normalement fermé comprend une première résistance connectée à la base du premier transistor, la dite première résistance permettant d'appliquer le signal électrique de commande à ladite base du premier transistor ;
- l'interrupteur normalement fermé comprend une seconde résistance connectée entre la base du second transistor et le collecteur du second transistor ;
- le second transistor est un transistor Darlington ;
- le circuit comprend un dispositif de pilotage du sens de la tension délivrée par la source de tension, de préférence, monté en parallèle de la source de tension, ledit polariseur étant configuré pour polariser la tension issue de la source de tension.

L'invention concerne également un dispositif électrique de fermeture d'un circuit carburant d'un aéronef alimenté au moyen d'un circuit électrique d'alimentation selon l'invention.

Les avantages de l'invention sont multiples.

Le dispositif est peu encombrant et fiable en termes de niveau de sécurité. Il est résistant aux contraintes environnementales notamment thermiques et son temps de réponse est court. Enfin, son implémentation est peu complexe.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1 illustre schématiquement un circuit de commande d'un équipement électrique de sécurité selon l'invention ;
- la figure 2 illustre un exemple de réalisation d'un circuit de commande d'un équipement électrique selon un mode de réalisation préféré de l'invention.

Sur l'ensemble des figures les éléments similaires portent des références identiques.

### DESCRIPTION DETAILLEE DE L'INVENTION

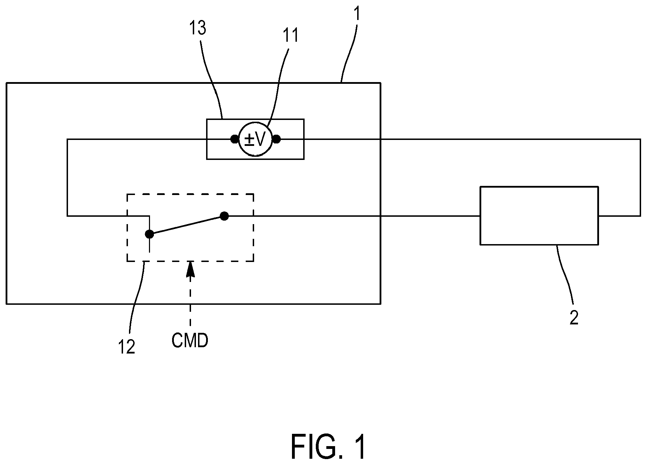

La **figure 1** illustre schématiquement un circuit de commande 1 d'un équipement électrique 2 selon l'invention.

Le circuit de commande reçoit en entrée un signal électrique discret de commande CMD. On considère que le signal électrique discret de commande CMD est soit un signal logique '1' soit un signal logique '0'. On considère qu'un signal électrique discret de commande CMD='0' est également assimilé à une absence de commande.

On entend ici par équipement électrique 2 un servomoteur bistable comprenant deux états stables. En effet, on considère que l'équipement électrique 2 change d'état dès lors que sa commande est modifiée. On considère également, que l'équipement électrique, dès lors qu'il n'est plus alimenté, maintien la position dans laquelle il était.

Le circuit de commande da la figure 1 comprend une source 11 de tension configurée pour délivrer une tension d'amplitude ayant pour valeur absolue |V| selon un sens positif ou négatif. La source 11 de tension délivre donc une tension d'alimentation égale à ±V.

Cette source 11 de tension qui commande l'équipement électrique 2. En effet, en fonction du sens de la tension, le courant passant au travers de l'équipement électrique est soit positif soit négatif.

Le circuit de commande comprend également un dispositif 13 de pilotage du sens de la tension délivrée par la source de tension qui permet de piloter le sens de la tension ±V issue de la source de tension 11. Ce dispositif 13 de pilotage du sens de la tension délivrée par la source de tension est de préférence monté en parallèle à la source de tension.

Le circuit de commande comprend en outre un interrupteur 12 normalement fermé configuré pour isoler l'équipement électrique 2 de la source de tension. L'interrupteur 12 normalement fermé est connecté entre la source 11 de tension et l'équipement 2 électrique.

On considère que l'interrupteur 12 normalement fermé présente un état 'fermé' laissant passer un courant et un état 'ouvert' ne laissant pas passer de courant. En outre, l'interrupteur normalement fermé est tel qu'il est fermé en l'absence d'un signal électrique discret de commande. L'état fermé est donc l'état « naturel » ce l'interrupteur normalement fermé.

Le circuit de commande 1 permet sous certaines conditions d'isoler l'équipement électrique 2 de la source de tension et permet donc de laisser l'équipement électrique 2 dans l'état précédent, c'est-à-dire lorsqu'il était alimenté.

En particulier, l'interrupteur 12 est sensible au signal électrique discret de commande CMD pour un seul sens de la tension.

En conséquence, l'interrupteur 12 normalement fermé est à l'état 'fermé' quel que soit le signal électrique discret de commande CMD (CMD = '0' ou CMD = '1') pour un seul sens de la tension.

On considère ici que l'interrupteur 12 est sensible au signal électrique de commande CMD pour une tension d'alimentation positive, égale à +V. Ceci permet d'avoir une forte intégrité dans la commande de l'équipement électrique.

Compte tenu de ce fonctionnement, l'interrupteur 12 normalement fermé est :
- 'fermé' quelle que soit la valeur du signal électrique discret de commande CMD ('0' ou '1') et lorsque la tension d'alimentation est négative, égale à -V;
- 'ouvert' lorsque la tension d'alimentation est positive, égale à +V, et que le signal électrique discret de commande CMD est à l'état '1' ;
- 'fermé' lorsque la tension d'alimentation est positive, égale à +V, et que le signal électrique discret de commande CMD est à l'état '0'.

En conséquence, on a un fonctionnement de l'interrupteur 12 normalement fermé qui est inhibé pour une tension d'alimentation égale à -V (polarisation négative).

On décrit dans ce qui suit une application possible d'un tel circuit de commande.

On considère que l'équipement électrique 2 est un servomoteur qui selon sa position ouvrir ou fermer un circuit carburant du moteur d'un aéronef en fonction de l'état de l'aéronef.

Un équipement électrique 2 du type servomoteur est par exemple un électro clapet d'arrêt (ECA) bistable qui permet de commander l'ouverture et la fermeture d'arrivée de carburant dans le moteur de l'aéronef.

En particulier, pour commander l'ouverture il faut une tension dans un premier sens et pour commander la fermeture, il faut une tension dans un second sens, opposé au premier sens.

Des états de l'aéronef sont par exemple :
- démarrage du moteur : l'ECA est ouvert, du carburant est envoyé dans le circuit de carburant,
- moteur démarré : l'ECA est ouvert, du carburant est envoyé dans le circuit carburant,
- moteur en mode ralenti ou normal : l'ECA est ouvert, du carburant est envoyé dans le circuit carburant,
- défaut : l'ECA est fermé, pas de carburant envoyé dans le circuit carburant.

On considère que le signal électrique de commande CMD caractérise la vitesse du moteur de l'aéronef. Ainsi, au démarrage CMD = '0', moteur démarré CMD = '1', mode ralenti CMD = '1', défaut CMD = '0'.

Le fonctionnement ci-dessus est tel que l'on souhaite alimenter un circuit carburant d'un aéronef dans certaines conditions de vitesse du moteur et dès lors qu'en fonction de l'état de l'aéronef on perd le signal électrique de commande CMD = '0', l'équipement électrique doit fermer le circuit carburant.

Ainsi on a le fonctionnement suivant :
- Mode démarrage : la tension est négative, la tension d'alimentation est égale à '-V', le signal électrique discret de commande est égal à CMD = '0'.
   ∘ L'interrupteur normalement fermé est fermé, l'équipement électrique est alimenté pas une tension négative (et donc un courant négatif) correspondant à une alimentation du circuit carburant.
   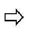 Le moteur peut démarrer.
- Mode moteur démarré : la tension est négative, la tension d'alimentation est égale à '-V', le signal électrique discret de commande est égal à CMD = '1'.
   ∘ L'interrupteur normalement fermé est fermé, l'équipement électrique est alimenté pas une tension négative (et donc un courant négatif) correspondant à une alimentation du circuit carburant.
   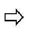 Le moteur est démarré et est alimenté en carburant.
- Mode ralenti ou normal: la tension est positive (le dispositif de pilotage du sens de la tension change le sens de la tension), la tension d'alimentation est égale à '=+V', le signal électrique discret de commande est égal à CMD = '1'.
   ∘ L'interrupteur normalement fermé est ouvert, l'équipement électrique n'est plus alimenté, l'équipement électrique n'a pas changé d'état.
   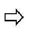 Le moteur est démarré et est alimenté en carburant.
- Mode défaut : la tension est positive, la tension d'alimentation est égale à '=+V', le signal électrique discret de commande est égal à CMD = '0' suite à une perte de l'information de vitesse.
   ∘ L'interrupteur normalement fermé se ferme, l'équipement électrique est alimenté par une tension positive, l'équipement électrique change d'état.
   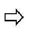 Le moteur n'est plus alimenté en carburant, le circuit carburant étant fermé.

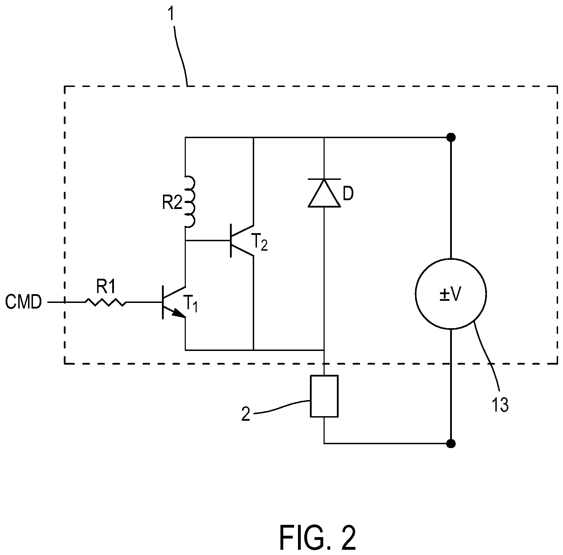

On a illustré sur la **figure 2****,** une réalisation possible du circuit de commande tel que décrit ci-dessus.

La source de tension délivre une tension d'alimentation selon un sens grâce au dispositif 13 de pilotage du sens de la tension délivrée par la source de tension.

L'interrupteur normalement fermé comprend un premier transistor T1 NPN commandé par le signal électrique discret de commande CMD et un second transistor T2 NPN, le collecteur du premier transistor T1 est connecté à la base du second transistor T2.

En outre, l'émetteur du premier transistor T1 étant connecté à l'émetteur du second transistor T2, les émetteurs étant connectés à l'équipement 2.

Bien que le circuit soit décrit ci-dessus en termes de transistors NPN, la présente invention est limitée aux transistors PNP. Dans ce cas, le montage des transistors est inversé (non illustré). Ainsi, un tel montage est que la commande du circuit de commande n'est pas référencée par rapport à la masse comme c'est le cas classiquement. Ainsi, dans l'invention, on a un circuit dont la commande est flottante, référencée à l'émetteur et non à la masse, permettant de simplifier le câblage lors de l'utilisation de l'interrupteur d'une part et ainsi de mettre en série plusieurs interrupteurs d'autre part afin de pouvoir réaliser une fonction logique différente et atteindre un haut niveau de sécurité en cas de défaillance

Ceci est en outre avantageux car cela permet de monter en série plusieurs circuit de commande afin d'augmenter la sécurité. En effet, dans ce cas un circuit de commande défaillant peut être compensé par un autre circuit de commande en série.

Le circuit comprend également une diode D connectée entre l'équipement électrique 2 et la source 11 de tension, la diode D est polarisée dans le même sens que la source 11 de tension.

En outre, le circuit comprend une première résistance R1 connectée à la base du premier transistor T1, la première résistance R1 permet d'appliquer le signal électrique de commande CMD à la base du premier transistor T1.

En outre, une seconde résistance R2 est connectée entre la base du second transistor T2 et le collecteur du second transistor T2.

De manière avantageuse, le second transistor T2 est du type Darlington. Ceci présente l'avantage de limiter le courant de polarisation dans sa base afin de pouvoir augmenter la seconde résistance R2 et ainsi réduire le courant de fuite de l'interrupteur dans son état 'ouvert'.

Le fonctionnement de ce circuit est identique à celui décrit en relation avec la figure 1. En considérant le même exemple que précédemment on a :
- Mode démarrage :
   Seule la diode D est active et laisse passer le courant (de bas en haut). Les transistors sont ainsi montés en inverse du sens de la tension et aucun courant ne les traverse.
- Mode moteur démarré
   Seule la diode D est active et laisse passer le courant (de bas en haut). Les transistors sont ainsi montés en inverse du sens de la tension et aucun courant ne les traverse et ce quel que soit la valeur du signal électrique de commande CMD.
- Mode ralenti ou normal
   La diode D est maintenant en inverse du sens de la tension et est donc bloquée. Le signal électrique de commande CMD est égal à CMD='1' (dans l'hypothèse où aucun défaut moteur n'est présent) le courant dans la première résistance R1 permet de commander le premier transistor T1 en mode « passant » ce qui vient dériver le courant apporter par la seconde résistance R2 de manière à couper le second transistor T2.
- Mode défaut
   La diode D est maintenant en inverse du sens de la tension et est donc bloquée. Le signal électrique de commande CMD est égal à '0' et il n'y a donc plus de courant dans la première résistance R1 ce qui ouvre le premier transistor T1. Le courant apporté par la seconde résistance R2 passe donc dans la base du second transistor T2 ce qui permet de fermer ce dernier et donc de laisser le courant dans la charge.

## Revendications

1. Circuit de commande (1) d'un équipement (2) électrique, ledit circuit de commande (1) recevant en entrée un signal électrique discret (CMD) de commande,
le circuit de commande (1) comprenant
une source (11) de tension (±V) configurée pour alimenter le circuit selon une tension négative ou positive ;
un interrupteur (12) normalement fermé en l'absence de signal électrique discret (CMD) de commande et configuré pour isoler l'équipement électrique de la source de tension en fonction du signal électrique (CMD) de commande, ledit interrupteur étant connecté entre la source de tension et l'équipement (2) électrique ; l'interrupteur (12) étant sensible au signal électrique discret de commande (CMD) pour un seul sens de tension dans lequel l'interrupteur normalement fermé comprend un premier transistor (T1) PNP commandé par le signal électrique discret de commande (CMD) et un second transistor (T2) PNP, le collecteur du premier transistor (T1) étant connecté à la base du second transistor (T2), l'émetteur du premier transistor (T1) étant connecté à l'émetteur du second transistor (T2), les émetteurs étant connectés à l'équipement (2).

2. Circuit de commande selon la revendication 1, dans lequel l'interrupteur normalement fermé comprend une première résistance (R1) connectée à la base du premier transistor (T1), la dite première résistance (R1) permettant d'appliquer le signal électrique de commande (CMD) à ladite base du premier transistor (T1).

3. Circuit de commande selon l'une des revendications 1 à 2, dans lequel l'interrupteur normalement fermé comprend une seconde résistance (R2) connectée entre la base du second transistor (T2) et le collecteur du second transistor (T2).

4. Circuit électrique d'alimentation selon l'une des revendications 1 à 3, dans lequel le second transistor (T2) est un transistor Darlington.

5. Circuit électrique d'alimentation selon l'une des revendications 1 à 4, comprenant un dispositif (13) de pilotage du sens de la tension délivrée par la source de tension.

6. Circuit électrique d'alimentation selon la revendication 5, dans lequel le dispositif (13) de pilotage du sens de la tension délivrée par la source de tension est monté en parallèle de ladite source de tension.

7. Dispositif électrique de fermeture d'un circuit carburant d'un aéronef alimenté au moyen d'un circuit électrique d'alimentation selon l'une des revendications 1 à 6.

## Patentansprüche

1. Schaltung zur Steuerung (1) einer elektrischen Ausrüstung (2), wobei die Steuerschaltung (1) am Eingang ein diskretes elektrisches Steuersignal (CMD) empfängt,
wobei die Steuerschaltung (1) umfasst
eine Spannungs- (±V) -quelle (11), die ausgelegt ist, um die Schaltung gemäß einer negativen oder positiven Spannung zu versorgen;
einen Schalter (12), der normalerweise bei Abwesenheit eines diskreten elektrischen Steuersignals (CMD) geschlossen ist und ausgelegt, um die elektrische Ausrüstung von der Spannungsquelle in Abhängigkeit von dem elektrischen Steuersignal (CMD) zu isolieren, wobei der Schalter zwischen der Spannungsquelle und der elektrischen Ausrüstung (2) angeschlossen ist; wobei der Schalter (12) gegenüber dem diskreten elektrischen Steuersignal (CMD) nur für eine Spannungsrichtung sensibel ist, wobei der normalerweise geschlossenen Schalter einen ersten Transistor (T1) PNP umfasst, der von dem diskreten elektrischen Steuersignal (CMD) gesteuert wird, und einen zweiten Transistor (T2) PNP, wobei der Kollektor des ersten Transistors (T1) an die Basis des zweiten Transistors (T2) angeschlossen ist, wobei der Sender des ersten Transistors (T1) an den Sender des zweiten Transistors (T2) angeschlossen ist, wobei die Sender an die Ausrüstung (2) angeschlossen sind.

2. Steuerschaltung nach Anspruch 1, wobei der normalerweise geschlossene Schalter einen ersten Widerstand (R1) umfasst, der an die Basis des ersten Transistors (T1) angeschlossen ist, wobei der erste Widerstand (R1) die Anwendung des elektrischen Steuersignals (CMD) an der Basis des ersten Transistors (T1) gestattet.

3. Steuerschaltung nach einem der Ansprüche 1 bis 2, wobei der normalerweise geschlossene Schalter einen zweiten Widerstand (R2) umfasst, der zwischen der Basis des zweiten Transistors (T2) und dem Kollektor des zweiten Transistors (T2) angeschlossen ist.

4. Elektrische Versorgungsschaltung nach einem der Ansprüche 1 bis 3, wobei der zweite Transistor (T2) ein Darlington-Transistor ist.

5. Elektrische Versorgungsschaltung nach einem der Ansprüche 1 bis 4, umfassend eine Lenkvorrichtung (13) der Richtung der von der Spannungsquelle bereitgestellten Spannung.

6. Elektrische Versorgungsschaltung nach Anspruch 5, wobei die Lenkvorrichtung (13) der Richtung der von der Spannungsquelle bereitgestellten Spannung parallel zu der Spannungsquelle angebracht ist.

7. Elektrische Vorrichtung zum Verschließen eines Kraftstoffkreises eines Luftfahrzeugs, die mittels einer elektrischen Versorgungsschaltung nach einem der Ansprüche 1 bis 6 versorgt wird.

## Claims

1. Control circuit (1) for an electrical device (2), said control circuit (1) receiving as input a discrete electric control signal (CMD),
the control circuit (1) comprising
a voltage (±V) source (11) configured to power the circuit according to a negative or positive voltage;
a switch (12) that is normally closed in the absence of a discrete electric control signal (CMD) and configured to isolate the electrical device from the voltage source as a function of the electric control signal (CMD), said switch being connected between the voltage source and the electrical device (2); the switch (12) being sensitive to the discrete electric control signal (CMD) for a single voltage direction wherein the normally closed switch comprises a first PNP transistor (T1) controlled by the discrete electric control signal (CMD) and a second PNP transistor (T2), the collector of the first transistor (T1) being connected to the base of the second transistor (T2), the emitter of the first transistor (T1) being connected to the emitter of the second transistor (T2), the emitters being connected to the device (2).

2. Control circuit according to claim 1, wherein the normally closed switch comprises a first resistor (R1) connected to the base of the first transistor (T1), said first resistor (R1) allowing the electric control signal (CMD) to be applied to said base of the first transistor (T1).

3. Control circuit according to one of claims 1 to 2, wherein the normally closed switch comprises a second resistor (R2) connected between the base of the second transistor (T2) and the collector of the second transistor (T2).

4. Electric power supply circuit according to one of claims 1 to 3, wherein the second transistor (T2) is a Darlington transistor.

5. Electric power supply circuit according to one of claims 1 to 4, comprising a device (13) for controlling the direction of the voltage transmitted by the voltage source.

6. Electric power supply circuit according to claim 5, wherein the device (13) for controlling the direction of the voltage transmitted by the voltage source is mounted in parallel with said voltage source.

7. Electric device for closing a fuel circuit of an aircraft powered by means of an electric power supply circuit according to one of claims 1 to 6.
